(19) Europäisches Patentamt
European Patent Office
Office européen des brevets

(11) **EP 4 757 171 A1**

(12) **EUROPEAN PATENT APPLICATION**

(43) Date of publication:
**10.06.2026 Bulletin 2026/24**

(21) Application number: **24307050.5**

(22) Date of filing: **06.12.2024**

(51) International Patent Classification (IPC):
**H02P 29/024** $^{(2016.01)}$

(52) Cooperative Patent Classification (CPC):
**H02P 29/024**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Schneider Toshiba Inverter Europe SAS**
**27120 Pacy-sur-Eure (FR)**

(72) Inventors:
• **SURROOP, Dilshad**
**93200 SAINT DENIS (FR)**

• **BENBERKANE, Sofiane**
**78300 POISSY (FR)**
• **TFAILY, Ali**
**92500 RUEIL MALMAISON (FR)**
• **FRAPPÉ, Emmanuel**
**92100 BOULOGNE (FR)**
• **JEBAI, Al Kassem**
**27200 VERNON (FR)**

(74) Representative: **Plasseraud IP**
**104 Rue de Richelieu**
**CS92104**
**75080 Paris Cedex 02 (FR)**

(54) **METHODS FOR DETECTING A FAULT IN AN ELECTRIC MOTOR AND APPARATUSES FOR IMPLEMENTING THE SAME**

(57) A method for detecting a fault in an electric motor, the method comprising, by a motor health monitoring function of an electric motor system comprising the electric motor and a motor drive configured for driving the electric motor, wherein the motor drive is electrically coupled to a supply network for power supply of the motor drive through power supply network signals, and is electrically coupled to the electric motor through terminals for driving the electric motor through motor supply signals: computing a network signals imbalance value that represents imbalance among the power supply network signals; obtaining a motor signals imbalance value that represents imbalance among electrical signals output by the electrical motor; detecting occurrence of an electric fault in the motor based on the network signals imbalance value and the motor imbalance value.

FIG. 3

EP 4 757 171 A1

**Description**

The present disclosure relates to the field of electric motors and their uses, in particular to apparatuses configured for detecting a fault in an electric motor.

Electric motor drives (e.g. electric (e.g. induction) motor drives) are typically designed to operate with any electrical (e.g. induction) motor, based on driving parameters which are determined during a measuring phase sometimes referred to as a "motor tuning" phase.

A motor drive is typically configured to, based on an electrical signal received from a supply network (e.g. an energy supplier network), generate a setpoint signal which is fed to the motor to which the motor drive is coupled for controlling the operations thereof.

As the operations of the motor are controlled by the motor drive, it is desirable to detect at the motor drive the potential occurrence of a fault in the motor, so as to adapt (correct) accordingly, for example in real time or near-real time, the setpoint signal fed to the motor, or to stop the motor in order to avoid that the fault worsens.

There is therefore a need for providing improved schemes for configuring a motor drive and apparatuses implementing the same that address at least some of the above-described drawbacks and shortcomings of the conventional technology in the art.

It is an object of the present subject disclosure to provide improved schemes for configuring a motor drive and apparatuses implementing the same.

Another object of the present subject disclosure is to provide an improved scheme for configuring a motor drive and apparatus implementing the same for alleviating the above-described drawbacks and shortcomings of conventional schemes, in particular in that the proposed scheme for configuring a motor drive may allow detection by the motor drive of a fault in the motor.

Yet another object of the present subject disclosure is to provide an improved scheme for configuring a motor drive and apparatus implementing the same for alleviating the above-described drawbacks and shortcomings of conventional schemes, in particular in that the proposed scheme for configuring a motor drive may allow dynamically adapting a setpoint signal fed to a motor upon detecting by the motor drive a fault in the motor.

To achieve these objects and other advantages and in accordance with the purpose of the present subject disclosure, as embodied and broadly described herein, in one aspect of the present subject disclosure, a method for detecting a fault in an (multi-phase) electric motor (e.g. a 3-phase electric (induction) motor) is proposed. The method comprises, by a motor health monitoring function of an electric motor system comprising the electric motor and a motor drive configured for driving the electric motor, wherein the motor drive is electrically coupled to a supply network for power supply of the motor drive through multi-phase power supply network signals, and is electrically (operatively) coupled to the electric motor through terminals (in some embodiments an electrical coupling interface) for driving the electric motor through multi-phase motor supply (setpoint) signals: obtaining (in some embodiments determining) a network signals imbalance value that represents (a level of) imbalance among phases of the multi-phase power supply network signals; obtaining (in some embodiments determining) a motor signals imbalance value that represents (a level of) imbalance among electrical signals output by the electrical motor; determining occurrence or not of an electric fault in the motor based on the network signals imbalance value and the motor imbalance value.

The proposed method advantageously provides a scheme that may be used for detecting a fault in an electric motor based (only) on information that is collected at a motor drive coupled to the electric motor.

Advantageously, the present subject disclosure provides that in some embodiments the use of a network signals imbalance value and a motor signals imbalance value (for example a comparison of both values with each other) may allow for the identification of faults in the motor based on the principle that a significant increase in the motor's (currents, voltages) imbalance, relative to the network (grid) (currents, voltages) imbalance, is indicative of internal issues within the motor.

In one or more embodiments, the electric fault may be a short-circuit in the motor, such as, for example, one or more of an inter-turn short-circuit and a phase short-circuit.

In one or more embodiments, an occurrence of the electric fault in the motor may be detected based on a comparison of the network signals imbalance value with the motor signals imbalance value.

In one or more embodiments, the network signals imbalance value may be computed based on at least one line-to-line electrical quantity deviation among electrical signals (e.g. voltages, currents) fed by the supply network.

In one or more embodiments, the motor signals imbalance value may be computed based on at least one line-to-line electrical quantity deviation in electrical signals (e.g. currents) output by the electrical motor.

In one or more embodiments, the network signals imbalance value may comprise an estimate of a level of imbalance in the network. In some embodiments, the estimate of the level of imbalance in the network may be determined using the power supply network signals. In some embodiments, the estimate of the level of imbalance in the network may be determined heuristically based on experiments.

In one or more embodiments, the estimate of the level of imbalance in the network may be computed based on a ratio of an aggregate network imbalance value to a (first) predetermined nominal network electrical quantity (e.g. voltage) value. In some embodiments, the aggregate network imbalance value may be computed based on one or more (e.g. a plurality of) line-to-line electrical quantity (e.g. voltage) deviations among electrical signals fed by the network (to the motor drive).

In one or more embodiments, the motor signals imbalance value may comprise an estimate of a level of imbalance between phases of the motor. In some embodiments, the estimate of the level of imbalance between phases of the motor may be determined using the electrical signals output by the electrical motor.

In one or more embodiments, the estimate of the level of imbalance in the motor may be computed based on a ratio of an aggregate motor imbalance value computed based on one or more (e.g. a plurality of) line-to-line electrical quantity (e.g. current) deviations among electrical (e.g. current) signals output by the electrical motor to a (second) predetermined nominal electrical quantity (e.g. current) value output by the electrical motor.

In one or more embodiments, the network signals imbalance value may comprise an estimate of a level of imbalance in the network. In some embodiments, the motor signals imbalance value may comprise an estimate of a level of imbalance in the motor. In some embodiments, the occurrence of the electric fault in the motor may be detected based on determining that the estimate of the level of imbalance in the motor exceeds the estimate of the level of imbalance in the network.

In one or more embodiments, the network signals imbalance value may comprise an estimate of a level of imbalance in the network. In some embodiments, the motor signals imbalance value may comprise an estimate of a level of imbalance in the motor. In some embodiments, a determination of no occurrence of the electric fault in the motor may be made based on determining that the estimate of the level of imbalance in the motor is substantially equal to the estimate of the level of imbalance in the network.

In one or more embodiments, the motor may be a 3-phase induction motor.

In another aspect of the present subject disclosure, an apparatus is proposed, which comprises a processor, a memory operatively coupled to the processor, and an interface for coupling to an electrical electric (e.g. induction) motor to be driven by the apparatus, wherein the apparatus is configured to perform a method as proposed in the present subject disclosure.

In yet another aspect of the present subject disclosure, a non-transitory computer-readable medium encoded with executable instructions which, when executed, causes an apparatus comprising a processor operatively coupled with a memory, to perform a method as proposed in the present subject disclosure, is proposed.

In yet another aspect of the present subject disclosure, a computer program product comprising computer program code tangibly embodied in a computer readable medium, said computer program code comprising instructions to, when provided to a computer system and executed, cause said computer to perform a method as proposed in the present subject disclosure, is proposed. In another aspect of the present subject disclosure, a data set representing, for example through compression or encoding, a computer program as proposed herein, is proposed.

It should be appreciated that the present subject disclosure can be implemented and utilized in numerous ways, including without limitation as a process, an apparatus, a system, a device, and as a method for applications now known and later developed. These and other unique features of the system disclosed herein will become more readily apparent from the following description and the accompanying drawings.

## Brief description of the drawings

The present subject disclosure will be better understood and its numerous objects and advantages will become more apparent to those skilled in the art by reference to the following drawings, in conjunction with the accompanying specification, in which:

Figure 1 illustrates an exemplary electric motor system to which the proposed methods may be applied according to one or more embodiments;
Figure 2 is a diagram that illustrates an exemplary scheme for detecting a fault in an electric motor according to one or more embodiments;
Figure 3 illustrates an exemplary scheme for determining a status of an electric motor (e.g. occurrence or not of an electric fault) according to one or more embodiments;
Figure 4 illustrates an apparatus according to one or more embodiments.

## Description of embodiments

For simplicity and clarity of illustration, the drawing figures illustrate the general manner of construction, and descriptions and details of well-known features and techniques may be omitted to avoid unnecessarily obscuring the discussion of the described embodiments of the invention. Additionally, elements in the drawing figures are not necessarily drawn to scale. For example, the dimensions of some of the elements in the figures may be exaggerated relative to other elements to help improve understanding of embodiments of the present invention. Certain figures may be shown in an idealized fashion in order to aid understanding, such as when structures are shown having straight lines, sharp angles, and/or parallel planes or the like that under real-world conditions would likely be significantly less symmetric and orderly. The same reference numerals in different figures denote the same elements, while similar reference numerals may, but do not necessarily, denote similar elements.

In addition, it should be apparent that the teaching herein can be embodied in a wide variety of forms and that any specific structure and/or function disclosed herein is merely representative. In particular, one skilled in the art will appreciate that an aspect disclosed herein can be implemented independently of any other aspects and that several aspects can be combined in various ways.

The present disclosure is described below with reference to functions, engines, block diagrams and flowchart illustrations of the methods, systems, and computer program according to one or more exemplary embodiments. Each described function, engine, block of the block diagrams and flowchart illustrations can be implemented in hardware, software, firmware, middleware, microcode, or any suitable combination thereof. If implemented in software, the functions, engines, blocks of the block diagrams and/or flowchart illustrations can be implemented by computer program instructions or software code, which may be stored or transmitted over a computer-readable medium, or loaded onto a general purpose computer, special purpose computer or other programmable data processing apparatus to produce a machine, such that the computer program instructions or software code which execute on the computer or other programmable data processing apparatus, create the means for implementing the functions described herein.

Embodiments of computer-readable media includes, but are not limited to, both computer storage media and communication media including any medium that facilitates transfer of a computer program from one place to another. As used herein, a "computer storage media" may be any physical media that can be accessed by a computer or a processor. In addition, the terms « memory » and « computer storage media" include any type of data storage device, such as, without limitation, a hard drive, a flash drive or other flash memory devices (e.g. memory keys, memory sticks, key drive, SSD drives), CD-ROM or other optical storage, DVD, magnetic disk storage or other magnetic storage devices, memory chip(s), Random Access Memory (RAM), Read-Only-Memory (ROM), Electrically-erasable programmable read-only memory (EEPROM), smart cards, or any other suitable medium that can be used to carry or store program code in the form of instructions or data structures which can be read by a computer processor, or a combination thereof. Also, various forms of computer-readable media may transmit or carry instructions to a computer, including a router, gateway, server, or other transmission device, wired (coaxial cable, fiber, twisted pair, DSL cable) or wireless (infrared, radio, cellular, microwave). The instructions may comprise code from any computer-programming language, including, but not limited to, assembly, C, C++, Python, Visual Basic, SQL, PHP, and JAVA.

Unless specifically stated otherwise, it will be appreciated that throughout the following description discussions utilizing terms such as processing, computing, calculating, determining, or the like, refer to the action or processes of a computer or computing system, or similar electronic computing device, that manipulate or transform data represented as physical, such as electronic, quantities within the registers or memories of the computing system into other data similarly represented as physical quantities within the memories, registers or other such information storage, transmission or display devices of the computing system.

As used herein, the terms "comprise," "include," "have," and any variations thereof, are intended to cover a non-exclusive inclusion, such that a process, method, article, or apparatus that comprises a list of elements is not necessarily limited to those elements, but may include other elements not expressly listed or inherent to such process, method, article, or apparatus.

Additionally, the word "exemplary" is used herein to mean "serving as an example, instance, or illustration". Any embodiment or design described herein as "exemplary" is not necessarily to be construed as preferred or advantageous over other embodiments or designs.

In the present subject disclosure, the terms "coupled" and "connected", along with their derivatives, may be indifferently used to indicate that two or more elements are in direct physical or electrical contact with each other, or two or more elements are not in direct contact with each other, but yet still co-operate or interact with each other.

In the present subject disclosure, the terms "electrical motor," "electric motor" and "electric engine", may be indifferently used to refer to electrical machine that converts electrical energy into mechanical energy (such as kinetic energy - for example rotary or linear motion). The present disclosure may be implemented with any multi-phase electric motor, such as for example a multi-phase synchronous motor or asynchronous motor.

It should be understood that embodiments of the present subject disclosure may be used for managing operations of an electric motor drive configured for driving an electric (e.g. induction) motor, in particular, although not limited to, an electric (e.g. induction) motor drive configured for driving an asynchronous electric (e.g. induction) motor.

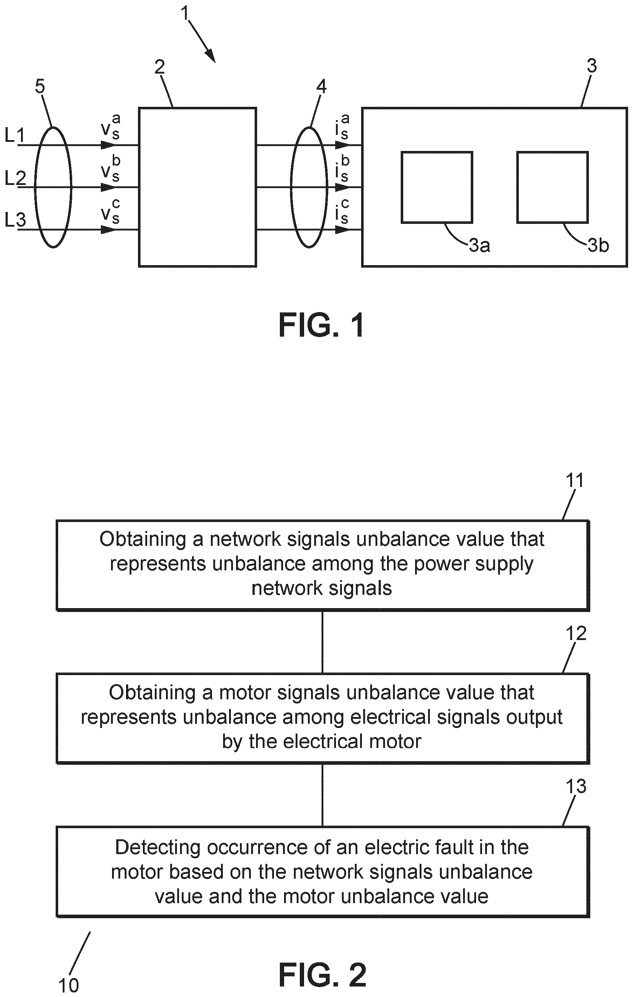

Figure 1 shows an exemplary electric motor system (1) to which the proposed methods may be applied according to one or more embodiments.

Shown on Fig. 1 is an electric motor system (1) comprising a motor drive (2) and an electric (e.g. induction) motor (3) which are operatively coupled with each other through an interface (4).

The electric (e.g. induction) motor (3) comprises a rotor (3a) and a magnetic core (which may sometimes be referred to as a "stator") (3b) which comprises a magnetic induction component (not shown on the figure), sometimes referred to as the "main induction" of the electric (e.g. induction) motor (3).

In some embodiments, a so-called "motor tuning" phase may be performed for determining configuration parameters of the motor drive (2) that corresponds to characteristics of the electric (e.g. induction) motor (3) so that the motor drive (2) be tuned for driving the electric (e.g. induction) motor (3).

In some embodiments the electric motor system (1) may comprise a motor health monitoring function (not represented on the figure) which, depending on the embodiment, may or not be implemented as an engine of the motor drive (2).

Depending on the embodiment, the motor health monitoring function may be implemented in software, as described above, or in hardware, such as an application specific integrated circuit (ASIC), or in the form of a combination of hardware and software, such as for example a software program intended to be loaded and executed on a component of FPGA (Field Programmable Gate Array) type.

Depending on the embodiment, the motor drive (2) may be implemented in software, as described above, or in hardware, such as an application specific integrated circuit (ASIC), or in the form of a combination of hardware and software, such as for example a software program intended to be loaded and executed on a component of FPGA (Field Programmable Gate Array) type.

As shown on Figure 1, the motor drive (2) may receive, for example from a supply network (e.g. a grid network) (not represented on the Figure) supply electric signals (5) for power supply of the motor drive (2). For example, in some embodiments, the motor drive (2) may receive a three-phase power supply signal, in which case the supply signals (5) may comprise three supply voltage signals $v_s^a$, $v_s^b$, and $v_s^c$.

The motor drive (2) is configured to supply one or more setpoint electrical signals through the coupling interface (4) to the electric motor (3) to drive operations thereof. For example, in some embodiments, the motor drive (2) is configured to supply current signals $i_s^a$, $i_s^b$, and $i_s^c$ to control the operations of the motor (3).

For example, in some embodiments, the drive may be configured to implement a speed variator function, and as such may be configured to receive supply electrical signals and process such signals (e.g., in case of sinusoidal signals, process the frequency and/or amplitude of such signals) so as to generate electrical signals that feed an electric motor for controlling a speed parameter thereof (e.g. the rotational speed of a shaft driven by the motor). The electrical signals fed to the motor may typically correspond to a setpoint signal fed into the motor (such as, for example, a torque setpoint ramp signal, a speed setpoint ramp signal, a voltage setpoint step signal, etc.).

The proposed scheme advantageously allows detecting (e.g. by a motor drive) the occurrence of a fault in the electric motor to which the drive is coupled, using data that are available at the motor drive.

For example, the proposed scheme may advantageously be used to detect, for example by a motor drive, the occurrence of an inter-turn short-circuit (ITSC) fault in the (stator of the) electric motor to which the drive is coupled. In some embodiments, the electrical signals fed to the motor may be voltage setpoint signals, which may be fed (applied) to the stator (3b) of the motor. Occurrence of a short-circuit in one of the phases supplied to the stator may occur for example in a case where the corresponding electric (stator) winding of the stator experiences high temperatures so that insulating material electrically insulating the (stator) winding (corresponding to the phase) from one or more other (stator) windings respectively corresponding to other respective phases may melt, thereby shorting two (stator) windings corresponding to different phases. The (stator) inter-turn short-circuit issue may rapidly become very problematic as it may spread to other parts of the electric motor circuitry and eventually fry the motor.

It is therefore desirable to rapidly detect a fault in the electric motor of the (stator) inter-turn short-circuit type so as to avoid further damage to the motor due to the spreading of an undetected fault.

The present subject disclosure advantageously provides that a fault of an electric motor such as a (stator) inter-turn short circuit may create an imbalance of the electric setpoint signals used by the motor, and as such may be detected through detecting an imbalance of the electric setpoint signals used by the motor.

For example, in a case where a three-phase voltage setpoint signal is provided by the motor drive to the electric motor for driving operations thereof, a (stator) inter-turn short circuit may be detected through detecting an imbalance among the three phases of the setpoint signal. In a case where no fault is occurring in the motor, the three phases of the setpoint signal may be (the motor having reached a steady state) sinusoidal signals of a same magnitude. A fault occurring on one of the phases may result in an imbalance appearing among the phases (e.g. the magnitude of one of the phases being different from (e.g. greater than) that of the two other phases), for example among current signals generated by voltage setpoint signals fed to the motor, so that the fault may be detected through detecting the imbalance.

However, the occurrence of an imbalance among the motor supply signals (e.g. among current signals generated by voltage setpoint signals fed to the motor) may not always be the symptom of a fault occurring in the motor. For example, an imbalance among the motor supply signals used for power supply of the motor drive and based on which the voltage setpoint signals fed to the motor may be generated may trigger an imbalance among the motor supply signals (e.g. among current signals generated by voltage setpoint signals fed to the motor). In such cases, a fault that may not be occurring but might nevertheless still be detected based on monitoring a potential imbalance occurring only among the motor supply signals may lead to a false alarm corresponding to an erroneous fault detection.

In order to avoid such erroneous fault detection for electrical faults in the motor that can be detected through detecting an imbalance occurring among the motor supply signals, the present subject disclosure advantageously provides that an electric fault in the motor may be detected based on monitoring both (a level of) imbalance among the power supply network signals and (a level of) imbalance among the motor supply signals.

Figure 2 is a diagram that illustrates an exemplary scheme (10) for detecting a fault in an electric motor according to one or more embodiments of the present subject disclosure.

One considers a motor drive electrically coupled to a multi-phase electric (e.g. induction) motor (e.g. a 3-phase electric (induction) motor), such as for example illustrated on Fig. 1, for driving the motor through motor supply (setpoint) signals. The motor drive may also be electrically coupled to a supply network for power supply of the motor drive through power supply network signals.

In one or more embodiments, a motor health monitoring function, that may be - depending on the embodiment - implemented in a motor health monitoring engine of an electric motor system comprising the electric motor and the motor drive (for example in the motor drive), may perform one or more of the following operations.

In one or more embodiments, a network signals imbalance value that represents (a level of) imbalance among the power supply network signals may be obtained (11) (in some embodiments determined, e.g. computed).

Depending on the embodiments, electrical signals input (fed) to the motor health monitoring function (by the power supply network) (e.g. for powering the apparatus hosting the motor health monitoring function) that may advantageously be used for implementing embodiments of the present disclosure may comprise one or more of voltage and current signals.

In some embodiments, voltage signals input to the motor health monitoring function (by the power supply network) may advantageously be used to collect information on the health state of the motor, and determine occurrence or not of an electric fault in the motor.

In one or more embodiments, a motor signals imbalance value that represents (a level of) imbalance among electrical signals output by the electrical motor may be obtained (12) (in some embodiments determined, e.g. computed).

In some embodiments, electrical signals input (fed) to the electrical motor (by the motor drive) (e.g. for driving operations of the motor through feeding power supply to the motor) may comprise voltage signals, so that the motor may be supplied with voltage signals for driving its operations. In contrast, electrical signals output by the electrical motor that may advantageously be used for implementing embodiments of the present disclosure may comprise current signals.

In some embodiments, current signals output by the motor may advantageously be used to collect information on the health state of the motor, and determine occurrence or not of an electric fault in the motor.

In one or more embodiments, occurrence or not of an electric fault in the motor may be determined (13) based on the network signals imbalance value and the motor imbalance value.

The proposed method advantageously provides a scheme that may be used for detecting a fault in an electric motor based (only) on information that is collected at a motor drive coupled to the electric motor.

Advantageously, the present subject disclosure provides that in some embodiments the use of a network signals imbalance value and a motor signals imbalance value (for example a comparison of both values with each other) may allow for the identification of faults in the motor based on the principle that a significant increase in the motor's (currents, voltages) imbalance, relative to the network (grid) (currents, voltages) imbalance, is indicative of internal issues within the motor.

In one or more embodiments, the electric fault may be a short-circuit in the motor, such as, for example, one or more of an inter-turn short-circuit and a phase short-circuit.

In one or more embodiments, an occurrence of the electric fault in the motor may be detected based on a comparison of the network signals imbalance value with the motor signals imbalance value.

In one or more embodiments, the network signals imbalance value may be computed based on at least one line-to-line electrical quantity deviation among electrical signals (e.g. voltages, currents) fed by the supply network. Depending on the embodiments, the electrical quantity used for computing the networks signal imbalance value may correspond to one or more of a voltage value and a current value. In some embodiments, it may be advantageously convenient to measure at least one line-to-line voltage deviation among voltage signals fed by the supply network, and use the at least one line-to-line voltage deviation to compute the network signals imbalance value.

In one or more embodiments, the motor signals imbalance value may be computed based on at least one line-to-line electrical quantity deviation in electrical signals (e.g. voltages, currents) output by the electrical motor. Depending on the embodiments, the electrical quantity used for computing the motor signals imbalance value may correspond to one or more of a voltage value and a current value. In some embodiments, it may be advantageously convenient to measure at least one line-to-line current deviation among current signals output by the motor, and use the at least one line-to-line current deviation to compute the motor signals imbalance value, as current signals output by the motor may be directly obtainable through measurements at the motor terminals (for example terminals through which the motor drive is connected to the motor).

In one or more embodiments, the network signals imbalance value may comprise an estimate of a level of imbalance in the network. In some embodiments, the estimate of the level of imbalance in the network may be determined using the power supply network signals, such as for example the voltage of phases of power supply network signals. In some embodiments, the estimate of the level of imbalance in the network may be determined heuristically based on prior experiments.

In one or more embodiments, the estimate of the level of imbalance in the network may be computed based on a ratio of an aggregate network imbalance value to a (first) predetermined nominal network electrical quantity (e.g. current, voltage) value. In some embodiments, the aggregate network imbalance value may be computed based on one or more (e.g. a plurality of) line-to-line electrical quantity (e.g. current, voltage) deviations between phases of electrical signals fed by the network (to the motor drive). Depending on the embodiments, an electrical quantity used for computing the aggregate network imbalance value may correspond to one or more of a voltage value and a current value. In some embodiments, it may be advantageously convenient to measure at least one line-to-line voltage deviation between voltage signals corresponding to respective phases fed by the supply network, and use the at least one line-to-line voltage deviation to compute the aggregate network imbalance value. In some embodiments, a plurality of line-to-line voltage deviations between respective phases of voltage signals fed by the supply network may be combined to compute the aggregate network imbalance value.

In one or more embodiments, the motor signals imbalance value may comprise an estimate of a level of imbalance between phases of the motor. In some embodiments, the estimate of the level of imbalance between phases of the motor may be determined using the electrical signals output by the electrical motor. Depending on the embodiments, an electrical quantity used for computing the motor signals imbalance value may correspond to one or more of a voltage value and a current value. In some embodiments, it may be advantageously convenient to measure at least one line-to-line current deviation between current signals corresponding to respective phases output by the motor, and use the at least one line-to-line current deviation to compute the motor signals imbalance value, as current signals output by the motor may be directly obtainable through measurements at the motor terminals (for example terminals through which the motor drive is connected to the motor).

In one or more embodiments, the estimate of the level of imbalance in the motor may be computed based on a ratio of an aggregate motor imbalance value computed based on one or more (e.g. a plurality of) line-to-line electrical quantity (e.g. voltage, current) deviations among electrical (e.g. voltage, current) signals output by the electrical motor to a (second) predetermined nominal electrical quantity (e.g. voltage, current) value output by the electrical motor.

In some embodiments, the aggregate motor imbalance value may be computed based on one or more (e.g. a plurality of) line-to-line electrical quantity (e.g. current, voltage) deviations between phases of electrical signals output by the motor. Depending on the embodiments, an electrical quantity used for computing the aggregate motor imbalance value may correspond to one or more of a voltage value and a current value. In some embodiments, it may be advantageously convenient to measure at least one line-to-line current deviation between current signals corresponding to respective phases output by the motor, and use the at least one line-to-line current deviation to compute the aggregate motor imbalance value. In some embodiments, a plurality of line-to-line current deviations between respective phases of current signals output by the motor may be combined to compute the aggregate motor imbalance value.

In one or more embodiments, the network signals imbalance value may comprise an estimate of a level of imbalance in the network. In some embodiments, the motor signals imbalance value may comprise an estimate of a level of imbalance in the motor. In some embodiments, the occurrence of the electric fault in the motor may be detected based on determining that the estimate of the level of imbalance in the motor exceeds (in some embodiments beyond a predefined error margin) the estimate of the level of imbalance in the network. In some embodiments, a determination of no occurrence of the electric fault in the motor may be made based on determining that the estimate of the level of imbalance in the motor is substantially equal to the estimate of the level of imbalance in the network. In some embodiments, a determination of no occurrence of the electric fault in the motor may be made based on determining that the estimate of the level of imbalance in the motor does not exceed (in some embodiments beyond a predefined error margin) the estimate of the level of imbalance in the network.

In one or more embodiments, the motor may be a 3-phase induction motor.

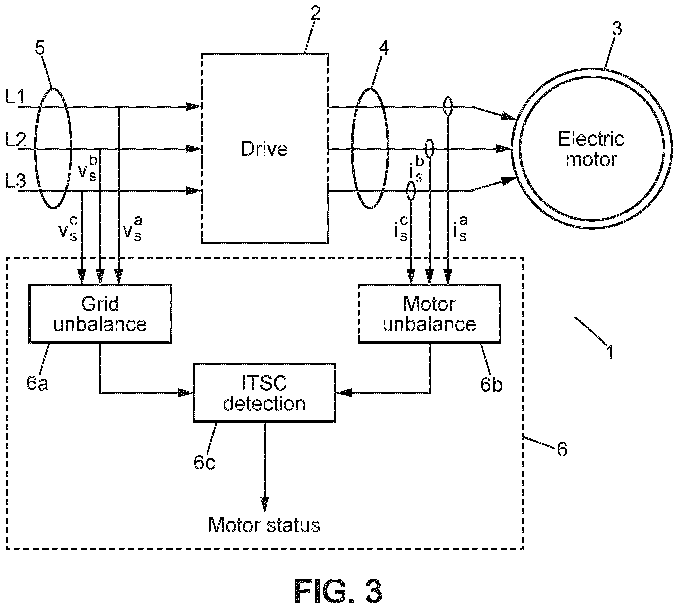

Figure 3 illustrates an exemplary scheme for determining a status of an electric motor (e.g. occurrence or not of an electric fault) according to one or more embodiments of the present subject disclosure.

Shown on Fig. 3 is an electric motor system (1) comprising a motor drive (2) and an electric (e.g. induction) motor (3) which are operatively coupled with each other through an interface (4).

As illustrated on Fig. 3, in some embodiments the electric motor system (1) may comprise a motor health monitoring function (6) which, depending on the embodiment, may or not be implemented as an engine of the motor drive (2).

Depending on the embodiment, the motor health monitoring function (6) may be implemented in software, as described above, or in hardware, such as an application specific integrated circuit (ASIC), or in the form of a combination of hardware and software, such as for example a software program intended to be loaded and executed on a component of FPGA (Field Programmable Gate Array) type.

As shown on Figure 3, the motor drive (2) may receive, for example from a supply network (e.g. a grid network) (not represented on the Figure) power supply network signals (5) for power supply of the motor drive (2). For example, in some embodiments, the motor drive (2) may receive a three-phase power supply signal, in which case the supply signals (5) may comprise three supply voltage signals $v_s^a$, $v_s^b$, and $v_s^c$, which may in some embodiments be sinusoidal signals.

The motor drive (2) is configured to supply one or more motor supply (setpoint) signals through the coupling interface (4) to the electric motor (3) to drive operations thereof. For example, in some embodiments, the motor drive (2) is configured to supply current signals $i_s^a$, $i_s^b$, and $i_s^c$ to control the operations of the motor (3). In some embodiments, the supply current signals $i_s^a$, $i_s^b$, and $i_s^c$ may be sinusoidal signals.

In one or more embodiments, a network signals imbalance value that represents (a level of) imbalance among the power supply network signals may be computed, in some embodiments by a grid imbalance determination engine (6a) of the motor health monitoring function (6). For example, in some embodiments, the grid imbalance determination engine (6a) may be configured to compute an imbalance indicator of the grid network, which may provide a network signals imbalance value.

For example, in one or more embodiments, an estimate of the imbalance of the grid network supplying the motor drive (2) (which may provide a network signals imbalance value) may be determined.

For example, in some embodiments, an estimate $U_{g,V}$ of the degree of imbalance in the network (grid) may be determined, for example using the following formula:

$$U_{g,V} := \frac{|U_{ab} - U_{bc}| + |U_{bc} - U_{ca}| + |U_{ca} - U_{ab}|}{U_{nom}}$$

where $U_{ij}$ ($i,j \in \{a, b, c\}$, $i \neq j$) is a (mean computed using absolute value integrand(s), e.g. RMS) line-to-line grid voltage, $U_{nom}$ is a predetermined value referred to as a nominal grid voltage, and $| \ |$ designates a norm operator (e.g. the absolute value). The value of the nominal grid voltage may be determined in view of voltage value(s) of signals supplied by the power supply network. For example, in France, the value of the nominal grid voltage may be chosen equal to 400 V between phases.

In this example, presence of an imbalance between line voltages $U_{ab}$ and $U_{bc}$ would be reflected in the corresponding deviation $|U_{ab} - U_{bc}|$ exhibiting a non-zero value (given a predefined acceptable error margin). Conversely, absence of an imbalance between line voltages $U_{ab}$ and $U_{bc}$ would be reflected in the corresponding deviation $|U_{ab} - U_{bc}|$ exhibiting a substantially zero value (given a predefined acceptable error margin). Likewise, presence of an imbalance between line voltages $U_{bc}$ and $U_{ca}$ would be reflected in the corresponding deviation $|U_{bc} - U_{ca}|$ exhibiting a non-zero value (given a predefined acceptable error margin), and presence of an imbalance between line voltages $U_{ca}$ and $U_{ab}$ would be reflected in the corresponding deviation $|U_{ca} - U_{ab}|$ exhibiting a non-zero value (given a predefined acceptable error margin). To the contrary, absence of an imbalance between line voltages $U_{bc}$ and $U_{ca}$ would be reflected in the corresponding deviation $|U_{bc} - U_{ca}|$ exhibiting a substantially zero value (given a predefined acceptable error margin), and absence of an imbalance between line voltages $U_{ca}$ and $U_{ab}$ would be reflected in the corresponding deviation $|U_{ca} - U_{ab}|$ exhibiting a substantially zero value (given a predefined acceptable error margin). As a consequence, the presence of imbalance in the network may advantageously be detected using the aggregate network imbalance $U_{g,V}$ value through one or more of the line-to-line voltage deviations $|U_{ab} - U_{bc}|$, $|U_{bc} - U_{ca}|$, and $|U_{ca} - U_{ab}|$ having a non-zero value (given a predefined acceptable error margin), leading to the aggregate network imbalance $U_{g,V}$ indicator having a non-zero value (given a predefined acceptable error margin). Conversely, the absence of imbalance in the network may advantageously be determined using the aggregate network imbalance $U_{g,V}$ value through all of the line-to-line voltage deviations $|U_{ab} - U_{bc}|$, $|U_{bc} - U_{ca}|$, and $|U_{ca} - U_{ab}|$ having a substantially null value (given a predefined acceptable error margin), leading to the aggregate network imbalance $U_{g,V}$ indicator also having a substantially null value (given a predefined acceptable error margin) in such cases.

A nominal network (grid) voltage value $U_{nom}$ may advantageously be used in one or more embodiments, for example as described in the above formula for calculating the aggregate network imbalance $U_{g,V}$ indicator, to determine a degree of imbalance in cases where imbalance is detected in the network. Calculating a degree of imbalance in the network may advantageously allow, in addition to detecting imbalance in the network, comparing such degree of imbalance in the network with a degree of imbalance in the motor. Such a comparison of a degree of imbalance in the network with a degree of imbalance in the motor may advantageously be used for determining that there is no additional imbalance in the motor as compared to that present in the network, and consequently avoiding a false alarm by detecting a fault in the motor in cases where the imbalance detected in the motor merely reflects that present in the network, and is no symptom of a fault occurring in the motor.

It will be appreciated by those having ordinary skill in the relevant art that any suitable imbalance metric for detecting imbalance in the network, e.g. through measuring a degree of imbalance in the network, such as, for example, using current signals received (e.g. by the motor drive) from the network, may be used in place of the above scheme for computing an estimate of the degree of imbalance in the network, which is given by way of example only.

Further, it will be appreciated by those having ordinary skill in the relevant art that any suitable method for detecting imbalance in the electrical signals received (e.g. by the motor drive) from the network, such as, for example, an imbalance observer or external sensors configured for providing knowledge of occurrence of an imbalance in the network, may be used in place of the schemes for computing a network signals imbalance value described in the present subject disclosure, which are given by way of example only

The network signals imbalance value may advantageously provide an indication of the stability and quality of the power supply, which is beneficial for the proper functioning of the motor.

In one or more embodiments, motor signals imbalance value that represents (a level of) imbalance among the motor supply signals may be computed, in some embodiments by a motor imbalance determination engine (6b) of the motor health monitoring function (6). For example, in some embodiments, the motor imbalance determination engine (6b) may be configured to compute an imbalance indicator of the motor, which may provide a motor signals imbalance value.

For example, in some embodiments, an estimate $U_{m,I}$ of the degree of imbalance in the motor's currents (which may provide a motor signals imbalance value) may be determined, for example using the following formula:

$$U_{m,I} := \frac{|I_b - I_a| + |I_c - I_b| + |I_a - I_c|}{I_{nom}}$$

where $I_j$ ($j \in \{a, b, c\}$) is a (mean, e.g. RMS) value of the line current $i_s^j$ output from the motor, $I_{nom}$ a nominal current of the motor, and | | designates a norm operator (e.g. the absolute value).

In this example, presence of an imbalance between currents $I_b$ and $I_a$ would be reflected in the corresponding deviation $|I_b - I_a|$ exhibiting a non-zero value (given a predefined acceptable error margin). Conversely, absence of an imbalance between currents $I_b$ and $I_a$ would be reflected in the deviation $|I_b - I_a|$ exhibiting a substantially zero value (given a predefined acceptable error margin). Likewise, presence of an imbalance between currents $I_c$ and $I_b$ would be reflected in the corresponding deviation $|I_c - I_b|$ exhibiting a non-zero value (given a predefined acceptable error margin), and presence of an imbalance between currents $I_a$ and $I_c$ would be reflected in the corresponding deviation $|I_a - I_c|$ exhibiting a non-zero value (given a predefined acceptable error margin). To the contrary, absence of an imbalance between the currents $I_c$ and $I_b$ would be reflected in the corresponding deviation $|I_c - I_b|$ exhibiting a substantially zero value (given a predefined acceptable error margin), and absence of an imbalance between currents $I_a$ and $I_c$ would be reflected in the corresponding deviation $|I_a - I_c|$ exhibiting a substantially zero value (given a predefined acceptable error margin). As a consequence, the presence of imbalance in the motor may advantageously be detected using the aggregate imbalance motor $U_{m,I}$ value through one or more of the current deviations $|I_b - I_a|$, $|I_c - I_b|$, and $|I_a - I_c|$ having a non-zero value (given a predefined acceptable error margin), leading to the aggregate imbalance motor $U_{m,I}$ indicator having a non-zero value (given a predefined acceptable error margin). Conversely, the absence of imbalance in the motor may advantageously be determined using the aggregate imbalance motor $U_{m,I}$ value through all of the current deviations $|I_b - I_a|$, $|I_c - I_b|$, and $|I_a - I_c|$ having a substantially null value (given a predefined acceptable error margin), leading to the aggregate imbalance motor $U_{m,I}$ indicator also having a substantially null value (given a predefined acceptable error margin) in such cases.

A nominal motor current value $I_{nom}$ may advantageously be used in one or more embodiments, for example as described in the above formula for calculating $U_{m,I}$, to determine a degree of imbalance in cases where imbalance is detected in the motor. Calculating a degree of imbalance in the motor may advantageously allow, in addition to detecting imbalance in the motor, comparing such degree of imbalance in the motor with a degree of imbalance in the network. Such a comparison of a degree of imbalance in the motor with a degree of imbalance in the network may advantageously be used for determining that there is no additional imbalance in the motor as compared to that present in the network, and consequently avoiding a false alarm by detecting a fault in the motor in cases where the imbalance detected in the motor merely reflects that present in the network, and is no symptom of a fault occurring in the motor.

In other embodiments, a different approach may be adopted giving priority to promptness in detecting a potential fault in the electric motor, potentially at the expense of a higher false alarm rate. For example, in the example illustrated by Fig. 3, in some embodiments, a fault in the motor may be determined based on at least one of the current deviations $|I_b - I_a|$, $|I_c - I_b|$, and $|I_a - I_c|$ having a non-zero value (given a predefined acceptable error margin). In some embodiments, a fault in the motor may be determined based on at least one motor electrical quantity (e.g. (output) voltage or (output) current) deviation having a non-zero value (given a predefined acceptable error margin).

It will be appreciated by those having ordinary skill in the relevant art that any suitable imbalance metric for detecting imbalance in the motor, e.g. through measuring a degree of imbalance in the network, such as, for example, using line voltage signals of the motor (e.g. measured at terminals of the motor), may be used in place of the above scheme for computing an estimate of the degree of imbalance in the motor, which is given by way of example only.

Further, it will be appreciated by those having ordinary skill in the relevant art that any suitable method for detecting imbalance in the electrical signals used by the motor for operating, may be used in place of the schemes for obtaining (in some embodiments by computing) a motor signals imbalance value described in the present subject disclosure, which are given by way of example only

The motor signals imbalance value may advantageously reflect an operational state of the motor (3) and may provide an indication regarding potential issues (faults) such as (stator) inter-turn short-circuits of the motor (3).

In one or more embodiments, occurrence of an electric fault in the motor may be detected based on the network signals imbalance value and the motor imbalance value, in some embodiments by a ITSC detection engine (6c) of the motor health monitoring function (6). For example, in some embodiments, the ITSC detection engine (6c) may be configured to compare the network signals imbalance value and the motor imbalance value.

For example, in some embodiments, once an estimate of a level of imbalance in the motor and an estimate of a level of imbalance in the network (grid) have been determined, these two estimates may be compared to obtain information on a health status of the motor (in particular with respect to ITSC) based on these estimates. In some embodiments, an aggregate network imbalance $U_{g,V}$ value and an aggregate imbalance motor $U_{m,I}$ value may be computed, for example as described above, and used as estimate of a level of imbalance in the network (grid) and estimate of a level of imbalance in the motor, respectively, for the comparison thereof.

In some embodiments, a determination as to whether or not the network is imbalanced may be made based on the level of imbalance in the network (given a predefined acceptable error margin). For example, in some embodiments, in cases where the estimate of the level of imbalance in the network is higher than a predefined network imbalance threshold (given a predefined acceptable error margin), a determination is made that the network is imbalanced.

In some embodiments, in cases where a determination is made that the network is imbalanced, it may be decided that the knowledge of the estimate of the level of imbalance in the motor may not be relevant (or suitable) for determining whether an electric fault (e.g. a (stator) short-circuit) (as a motor imbalance may likely be the direct consequence of the network imbalance).

In some embodiments, in cases where a determination is made that the network is not imbalanced (in some embodiments in cases where the estimate of the level of imbalance in the network is not higher than the predefined network imbalance threshold (given a predefined acceptable error margin)), a determination may be made as to whether or not the motor is imbalanced.

For example, in some embodiments, in cases where the estimate of the level of imbalance in the motor is higher than a predefined motor imbalance threshold (given a predefined acceptable error margin), a determination is made that the motor is imbalanced.

In some embodiments, in cases where a determination is made that the motor is imbalanced, it may be determined that an electric fault (e.g. a (stator) short-circuit) has likely occurred, and appropriate corrective or preventive actions may be taken for protecting the motor. Further, an alarm may be triggered to inform a user of the presence of a fault in the motor.

In some embodiments, in cases where a determination is made that the network is not imbalanced (in some embodiments in cases where the estimate of the level of imbalance in the network is not higher than the predefined network imbalance threshold (given a predefined acceptable error margin)), however where a determination is made that the motor is imbalanced, it may be determined that an electric fault (e.g. a (stator) short-circuit) has likely occurred, and appropriate corrective or preventive actions may be taken for protecting the motor. Further, an alarm may be triggered to inform a user of the presence of a fault in the motor.

In some embodiments, an aggregate network imbalance $U_{g,V}$ value and an aggregate imbalance motor $U_{m,I}$ value may be computed, for example as described above, and used as follows for determining occurrence or not of an electric fault in the motor based thereon:

In some embodiments, upon determining the aggregate network imbalance $U_{g,V}$ value, the aggregate network imbalance $U_{g,V}$ value may be compared with a predefined network imbalance threshold $\gamma > 0$ (given a predefined acceptable error margin). In some embodiments, in cases where $U_{g,V} > \gamma$, the network (grid) may be determined to be balanced. In some embodiments, in such cases, an aggregate imbalance motor $U_{m,I}$ value may not be used (or even calculated) as, assuming that in such cases it may be considered that the motor imbalance $U_{m,I}$ would be the direct consequence of the network (grid) imbalance, the knowledge of $U_{m,I}$ would not provide useful information for determining occurrence or not of an electric fault in the motor (e.g. a stator short-circuit).

In some embodiments, in cases where $U_{g,V} \leq \gamma$, an aggregate imbalance motor $U_{m,I}$ value may be calculated and used for comparison with a predefined motor imbalance threshold $\xi > 0$ (given a predefined acceptable error margin). In some embodiments, in cases where $U_{g,V} \leq \gamma$ and $U_{m,I} > \xi$, it may be determined that there is a high probability of fault (e.g. (stator) short-circuit in one of the stator phases), and appropriate corrective or preventive actions may be taken for protecting the motor. Further, an alarm may be triggered to inform a user of the presence of a fault in the motor.

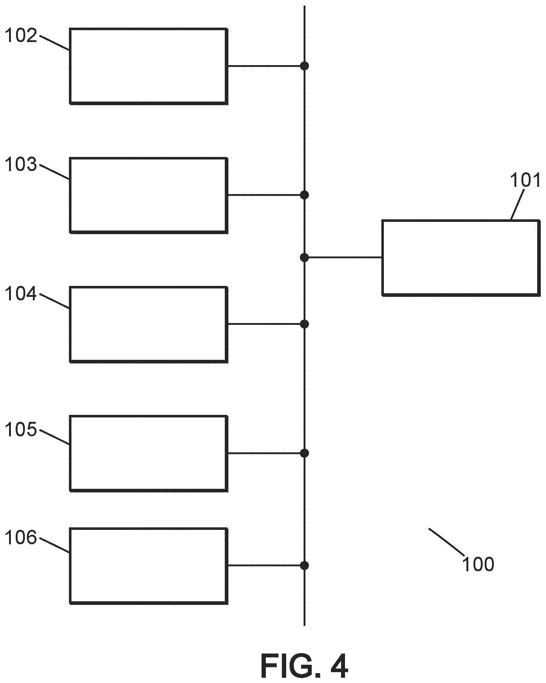

Fig. 4 illustrates an exemplary architecture of an apparatus 100 configured to implement methods in accordance with embodiments of the present subject disclosure. The apparatus 100 may, depending on the embodiment, be comprised in a motor drive or in a motor system management server.

As shown in Fig. 4, the apparatus 100 may comprise engines or functions that are similar to those comprised in the system 1 illustrated on Figs. 1 and 3, and may be configured to perform a method for detecting a fault in an electric motor in accordance with embodiments of the present subject disclosure.

The apparatus 100, which may comprise one or more computers, includes a control engine 101, a network imbalance management engine 102, a motor imbalance management engine 103, a fault detection engine 104, a data interface engine 105, and a memory 106.

In the architecture illustrated on Fig. 4, all of the network imbalance management engine 102, motor imbalance management engine 103, fault detection engine 104, data interface engine 105, and memory 106 are operatively coupled with one another through the control engine 101.

In some embodiments, the network imbalance management engine 102 is configured to perform various aspects of embodiments of one or more of the proposed methods for detecting a fault in an electric motor as described herein, such as obtaining a network signals imbalance value that represents (a level of) imbalance among the power supply network signals. In some embodiments, the network imbalance management engine 102 is configured to compute a network signals imbalance value that represents (a level of) imbalance among the power supply network signals.

In some embodiments, the motor imbalance management engine 103 is configured to perform various aspects of embodiments of one or more of the proposed methods for detecting a fault in an electric motor as described herein, such as obtaining a motor signals imbalance value that represents (a level of) imbalance among electrical signals output by the electrical motor. In some embodiments, the motor imbalance management engine 103 is configured to compute a motor signals imbalance value that represents (a level of) imbalance among electrical signals output by the electrical motor.

In some embodiments, the fault detection engine 104 is configured to perform various aspects of embodiments of one or more of the proposed methods for detecting a fault in an electric motor as described herein, such as determining occurrence or not of an electric fault (e.g. a (stator) short-circuit) in the motor based on the network signals imbalance value and the motor imbalance value.

In some embodiments, the data interface engine 105 is configured to receive as input power supply network signals and electrical signals output by the electrical motor, and to output an alarm (e.g. in case occurrence of an electric fault in the motor is determined), under the control of the control engine 101.

The control engine 101 includes a processor, which may be any suitable microprocessor, microcontroller, Field Programmable Gate Arrays (FPGA), Application Specific Integrated Circuits (ASIC), Digital Signal Processing chip, and/or state machine, or a combination thereof. According to various embodiments, one or more of the computers can be configured as a multi-processor computer having multiple processors for providing parallel computing. The control engine 101 may also comprise, or may be in communication with, computer storage media, such as, without limitation, the memory 106, capable of storing computer program instructions or software code that, when executed by the processor, causes the processor to perform the elements described herein. In addition, the memory 106 may be any type of data storage or computer storage medium, coupled to the control engine 101 and operable with the network imbalance management engine 102, the motor imbalance management engine 103, the fault detection engine 104, and the data interface engine 105 to facilitate management of data stored in association therewith, such as, for example, a cache memory, a data farm, a data warehouse, a data mart, a datacenter, a data cloud, or a combination thereof.

In embodiments of the present subject disclosure, the apparatus 100 is configured for performing one or more of the fault detection methods described herein. The apparatus 100 may in some embodiments be included in a motor drive configured for driving an electric motor.

It will be appreciated that the apparatus 100 shown and described with reference to Fig. 4 is provided by way of example only. Numerous other architectures, operating environments, and configurations are possible. Other embodiments of the node may include fewer or greater number of components and may incorporate some or all of the functionality described with respect to the apparatus components shown in Fig. 4. Accordingly, although the control engine 101, network imbalance management engine 102, motor imbalance management engine 103, fault detection engine 104, data interface engine 105, and memory 106 are illustrated as part of the apparatus 100, no restrictions are placed on the location and control of components 101 - 106. In particular, in other embodiments, any of components 101 - 106 may be part of different entities or computing systems.

The proposed method may be used for detecting a fault, such as for example a (stator) short-circuit, in any type of multi-phase electric motor.

While the invention has been described with respect to preferred embodiments, those skilled in the art will readily appreciate that various changes and/or modifications can be made to the invention without departing from the spirit or scope of the invention as defined by the appended claims.

Although this invention has been disclosed in the context of certain preferred embodiments, it should be understood that certain advantages, features and aspects of the systems, devices, and methods may be realized in a variety of other embodiments. Additionally, it is contemplated that various aspects and features described herein can be practiced separately, combined together, or substituted for one another, and that a variety of combination and sub-combinations of the features and aspects can be made and still fall within the scope of the invention. Furthermore, the systems and devices described above need not include all of the modules and functions described in the preferred embodiments.

Information and signals described herein can be represented using any of a variety of different technologies and techniques. For example, data, instructions, commands, information, signals, bits, symbols, and chips can be represented by voltages, currents, electromagnetic waves, magnetic fields or particles, optical fields or particles, or any combination thereof.

Depending on the embodiment, certain acts, events, or functions of any of the methods described herein can be performed in a different sequence, may be added, merged, or left out all together (e.g., not all described acts or events are necessary for the practice of the method). Moreover, in certain embodiments, acts or events may be performed concurrently rather than sequentially.

**Claims**

1. A method for detecting a fault in a multi-phase electric motor, the method comprising, by a motor health monitoring function of an electric motor system comprising the electric motor and a motor drive configured for driving the electric motor, wherein the motor drive is electrically coupled to a supply network for power supply of the motor drive through multi-phase power supply network signals, and is electrically coupled to the electric motor through an electrical coupling interface for driving the electric motor through multi-phase motor supply signals:

   obtaining a network signals imbalance value that represents imbalance among phases of the multi-phase power supply network signals;
   obtaining a motor signals imbalance value that represents imbalance among electrical signals output by the electrical motor;
   determining occurrence or not of an electric fault in the motor based on the network signals imbalance value and the motor imbalance value.

2. The method according to claim 1, wherein the electric fault is a short-circuit in the motor.

3. The method according to any of the preceding claims, wherein an occurrence of the electric fault in the motor is detected based on a comparison of the network signals imbalance value with the motor signals imbalance value.

4. The method according to any of the preceding claims, wherein the network signals imbalance value is computed based on at least one line-to-line electrical quantity deviation among electrical signals fed by the supply network.

5. The method according to any of the preceding claims, wherein the motor signals imbalance value is computed based on at least one line-to-line electrical quantity deviation in electrical signals output by the electrical motor.

6. The method according to any of the preceding claims, wherein the network signals imbalance value comprises an estimate of a level of imbalance in the network.

7. The method according to claim 6, wherein the estimate of the level of imbalance in the network is computed based on a ratio of an aggregate network imbalance value computed based on one or more (e.g. a plurality of) line-to-line electrical quantity deviations among electrical signals fed by the network to a predetermined nominal network electrical quantity value.

8. The method according to any of the preceding claims, wherein the motor signals imbalance value comprises an estimate of a level of imbalance between phases of the motor.

9. The method of claim 8, wherein the estimate of the level of imbalance in the motor is computed based on a ratio of an aggregate motor imbalance value computed based on one or more (e.g. a plurality of) line-to-line electrical quantity deviations among electrical signals output by the electrical motor to a nominal electrical quantity output by the electrical motor.

10. The method according to any of the preceding claims, wherein the network signals imbalance value comprises an estimate of a level of imbalance in the network, wherein the motor signals imbalance value comprises an estimate of a level of imbalance in the motor, and wherein the occurrence of the electric fault in the motor is detected based on determining that the estimate of the level of imbalance in the motor exceeds the estimate of the level of imbalance in the network.

11. The method according to any of the preceding claims, wherein the network signals imbalance value comprises an estimate of a level of imbalance in the network, wherein the motor signals imbalance value comprises an estimate of a level of imbalance in the motor, and wherein a determination of no occurrence of the electric fault in the motor is made based on determining that the estimate of the level of imbalance in the motor is substantially equal to the estimate of the level of imbalance in the network.

12. The method according to any of the preceding claims, wherein the motor is a 3-phase induction motor.

13. An apparatus, the apparatus comprising a processor, a memory operatively coupled to the processor, and an interface for coupling to an induction motor to be driven by the apparatus, wherein the apparatus is configured to perform a method according to any of claims 1 to 12.

14. A computer program product comprising computer program code tangibly embodied in a computer readable medium, said computer program code comprising instructions to, when provided to a computer system and executed, cause said computer to perform a method according to any of claims 1 to 12.

15. A data set representing, for example through compression or encoding, a computer program product according to claim 14.

FIG. 1

| Obtaining a network signals unbalance value that represents unbalance among the power supply network signals | 11 |

| Obtaining a motor signals unbalance value that represents unbalance among electrical signals output by the electrical motor | 12 |

| Detecting occurrence of an electric fault in the motor based on the network signals unbalance value and the motor unbalance value | 13 |

FIG. 2

FIG. 3

**FIG. 4**

# EP 4 757 171 A1

Europäisches
Patentamt

European
Patent Office

Office européen
des brevets

## EUROPEAN SEARCH REPORT

**Application Number**

EP 24 30 7050

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2020/124692 A1 (UENO TOMOTAKA [JP]) 23 April 2020 (2020-04-23) * paragraph [0016]; figure 1 * * paragraphs [0023], [0051] * * paragraph [0027] * ----- | 1,2,4-9, 12-15 | INV. H02P29/024 |
| Y | US 2003/067277 A1 (PARLOS ALEXANDER G [US] ET AL) 10 April 2003 (2003-04-10) * paragraph [0029]; figure 1 * ----- | 1,2,4-9, 12-15 | |

**TECHNICAL FIELDS SEARCHED (IPC)**

H02P
G01R

The present search report has been drawn up for all claims

| Place of search | Date of completion of the search | Examiner |
|---|---|---|
| Munich | 19 May 2025 | Schürle, Patrick |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**EP 4 757 171 A1**

## ANNEX TO THE EUROPEAN SEARCH REPORT
## ON EUROPEAN PATENT APPLICATION NO.

EP 24 30 7050

19-05-2025

| Patent document cited in search report | | Publication date | Patent family member(s) | | Publication date |
|---|---|---|---|---|---|
| US 2020124692 | A1 | 23-04-2020 | BR | 112020001028 A2 | 14-07-2020 |
| | | | CA | 3070339 A1 | 24-01-2019 |
| | | | CN | 110869776 A | 06-03-2020 |
| | | | EP | 3657181 A1 | 27-05-2020 |
| | | | JP | 6645625 B2 | 14-02-2020 |
| | | | JP | WO2019016850 A1 | 21-05-2020 |
| | | | KR | 20200023433 A | 04-03-2020 |
| | | | MY | 197715 A | 10-07-2023 |
| | | | RU | 2740149 C1 | 11-01-2021 |
| | | | US | 2020124692 A1 | 23-04-2020 |
| | | | WO | 2019016850 A1 | 24-01-2019 |
| US 2003067277 | A1 | 10-04-2003 | NONE | | |

For more details about this annex : see Official Journal of the European Patent Office, No. 12/82